# EUROPEAN PATENT APPLICATION

(11) **EP 2 256 828 A2**
(43) Date of publication of application: **01.12.2010**
(21) Application number: 10163818.7
(22) Date of filing: 25.05.2010
(51) Int. Cl.: H01L 31/18, H01L 27/142

(54) **Integrated thin-film solar cell and manufacturing method thereof**

(30) Priority: 26.05.2009 KR 20090045804
(71) Applicant: KISCO, Changwon-si Gyeongsangnam-do (KR); Korea Advanced Institute of Science and Technology, 305-701 Daejeon (KR)
(72) Inventor: Lim, Koeng Su, Yuseong-gu, Daejeon (KR); Jeon, Jin-Wan, Daejeon (KR)
(74) Representative: Zardi, Marco

(57) **Abstract**

Disclosed is a manufacturing method of an integrated thin-film solar cell. The method includes:
providing a substrate on which trenches are formed separately from each other by a predetermined interval; forming a first electrode layer on a portion of the bottom side and one side of each of the trenches by using a first conductive material; forming a solar cell layer on the first electrode layer and on a portion of the trench on which the first electrode layer is not formed; forming a second electrode layer by obliquely emitting a second conductive material so that the second conductive material is deposited on the solar cell layer; etching the solar cell layer formed on the trenches such that the first electrode layer is exposed; and forming a conductive layer by obliquely emitting a third conductive material and depositing the third conductive material on the second electrode layer such that the exposed first electrode layer is electrically connected to the second electrode layer.

## Description

### BACKGROUND

### 1. Field

This embodiment relates to an integrated thin-film solar cell and a manufacturing method thereof.

### 2. Description of the Related Art

A solar cell is a semiconductor device directly converting sunlight energy into electric energy. The solar cell is largely divided into a silicon based solar cell, a compound based solar cell and an organic solar cell in accordance with a material used for the solar cell.

The silicon based solar cell, according to a semiconductor phase, is divided into a single crystalline (c-Si) silicon solar cell, polycrystalline silicon (poly-Si) solar cell, and amorphous silicon (a-Si:H) solar cell.

Also, based on the thickness of a semiconductor, the solar cell is classified into a bulk (substrate) type solar cell and a thin-film type solar cell. The thin-film type solar cell includes a semiconductor layer having a thickness less than from several µm to several ten µm.

In the silicon based solar cell, the single crystalline and polycrystalline silicon solar cells belong to the bulk type solar cell and the amorphous silicon solar cell belongs to the thin-film type solar cell.

Meanwhile, the compound based solar cell includes a bulk type solar cell and a thin-film type solar cell. The bulk type solar cell includes Gallium Arsenide (GaAs) and Indium Phosphide (InP) of group III-V. The thin-film type solar cell includes Cadmium Telluride (CdTe) of group II-VI and Copper Indium Diselenide (CulnSe₂) of group I-III-VI. The organic based solar cell is largely divided into an organic molecule type solar cell, and an organic and inorganic complex type solar cell. In addition to this, there is a dye-sensitized solar cell. Here, all of the organic molecule type solar cell, the organic and inorganic complex type solar cell and the dye-sensitized solar cell belong to the thin-film type solar cell.

As such, among various kinds of solar cells, the bulk type silicon solar cell having a high energy conversion efficiency and a relatively low manufacturing cost has been widely and generally used for a ground power.

Recently, however, as a demand for the bulk type silicon solar cell rapidly increases, a material of the bulk type silicon solar cell becomes insufficient, so that the price of the solar cell is now rising. For this reason, it is absolutely required to develop a thin-film solar cell capable of reducing a currently required amount of a silicon material to a several hundredths thereof in order to produce an inexpensive large-scaled solar cell used for the ground power.

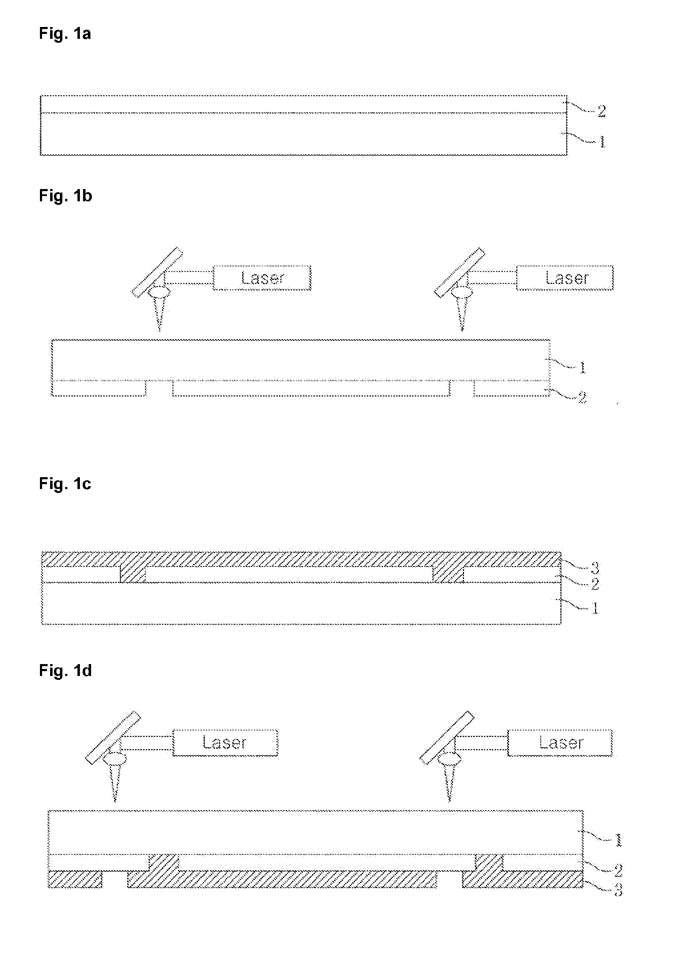

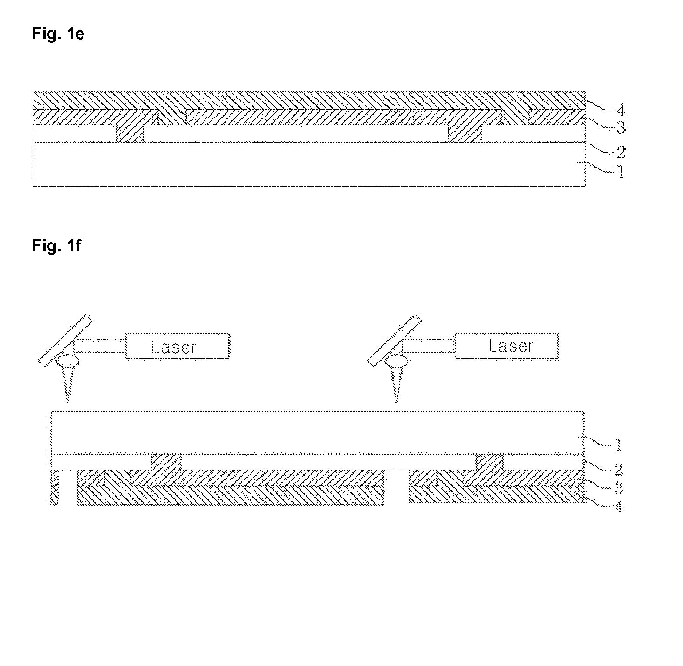

A method for integrating an a-Si:H thin-film solar cell which is now commercially used is shown in Figs. 1a to 1f. First, a transparent electrode layer 2 is formed on a glass substrate 1. In order to perform a laser-patterning on the transparent electrode layer 2, the substrate 1 is turned upside down and the transparent electrode 2 is laser-patterned. After performing the laser-patterning, the substrate 1 is turned upside down again and residues are cleaned and the substrate 1 is dried, and then a thin-film solar cell layer 3 is deposited. In order to perform the laser-patterning on the thin-film solar cell layer 3, the substrate 1 is turned upside down again and the thin-film solar cell layer 3 is laser-patterned. Subsequently, the substrate 1 can be cleaned again and a back side electrode layer 4 is formed. Finally, in order to perform the laser-patterning on the back surface electrode layer 4, the substrate 1 is turned upside down and the back surface electrode layer 4 is laser-patterned. Then, the substrate 1 can be cleaned again. The commercially used existing integration technology requires that the laser-patterning process should be performed at least three times so as to perform the laser-patterning process on the transparent electrode layer 2, the thin-film solar cell layer 3 and the back surface electrode layer 4. Due to both an area loss caused by each of the patterning processes and a process margin between the patterning processes, a non-effective interval of from about 250µm to 300µm between cells is generated. A non-effective area of from about 3% to 4% of a unit cell area is hereby created. Moreover, since the laser-patterning processes should be performed in the air, there are problems in that the thin-film solar cell performance is deteriorated by an atmospheric exposure, a productivity is deteriorated because of a process of which state in turn alternates between vacuum and atmosphere, and a clean room should be prepared through the overall process.

Since a conductive tape has a width of from 3mm to 5mm, a bus bar area to which a positive (+) terminal and a negative (-) terminal are connected in the thin-film solar cell integrated through an existing integration technology should have a width greater than that of the conductive tape. Many times of laser-patterning processes are required for performing the patterning process such that the thin-film solar cell layer and the back surface electrode layer have a width within a range greater than 3mm to 5mm. It is very inefficient to increase the number of the laser-patterning processes.

### SUMMARY

One aspect of this invention is a manufacturing method of an integrated thin-film solar cell. The method includes:

providing a substrate on which trenches are formed separately from each other by a predetermined interval;

forming a first electrode layer on a portion of the bottom side and one side of each of the trenches by using a first conductive material;

forming a solar cell layer on the first electrode layer and on a portion of the trench on which the first electrode layer is not formed;

forming a second electrode layer by obliquely emitting a second conductive material so that the second conductive material is deposited on the solar cell layer;

etching the solar cell layer formed on the trenches such that the first electrode layer is exposed; and

forming a conductive layer by obliquely emitting a third conductive material and depositing the third conductive material on the second electrode layer such that the exposed first electrode layer is electrically connected to the second electrode layer.

Another aspect of this invention is an integrated thin-film solar cell. The integrated thin-film solar cell includes:

a substrate on which trenches are formed separately from each other by a predetermined interval;

a first electrode layer formed on a portion of the bottom side of and one side of each of the trenches;

a solar cell layer formed on the substrate and on the first electrode layer such that a portion of the first electrode layer is exposed;

a second electrode layer formed on the solar cell layer; and

a conductive layer formed on the second electrode layer such that the exposed first electrode layer is electrically connected to the second electrode layer.

### BRIEF DESCRIPTION OF THE DRAWINGS

The embodiment will be described in detail with reference to the drawings.

Figs. 1a to 1f show a manufacturing method of an integrated thin-film solar cell according to a prior art.

Figs. 2a to 2k show a manufacturing method of an integrated thin-film solar cell according to a first embodiment of the present invention.

Figs. 3a to 3g show a manufacturing method of an integrated thin-film solar cell according to a second embodiment of the present invention.

Figs. 4a to 4h show a manufacturing method of an integrated thin-film solar cell according to a third embodiment of the present invention.

Figs. 5a to 5g show a manufacturing method of an integrated thin-film solar cell according to a fourth embodiment of the present invention.

### DETAILED DESCRIPTION OF EMBODIMENTS

Hereinafter, an exemplary embodiment of the present invention will be described in detail with reference to the accompanying drawings.

In the following description of the embodiments of the present invention, an integrated thin-film solar cell is manufactured by the following process.

A Substrate 200, 300, 400 and 500 is provided. Trenches 205a, 205b, 305a, 305c, 305e, 405, 406, 505a and 505b are formed separately from each other by a predetermined interval on the substrate 200, 300, 400 and 500.

A first conductive material is deposited on a portion of the bottom side of and one side of each of the trenches 205a, 205b, 305a, 305c, 305e, 405, 406, 505a and 505b, so that a first electrode layer 210a, 210b, 310a, 310b, 310b', 310c, 310c', 310d, 410a, 410a', 410b, 410b', 410c, 510a, 510b and 510c is formed.

A solar cell layer 230, 320, 420 and 520 is formed on the first electrode layer 210a, 210b, 310a, 310b, 310b', 310c, 310c', 310d, 410a, 410b, 410c, 510a, 510b and 510c and on the portion of the trench 205a, 205b, 305a, 305c, 305e, 405, 406, 505a and 505b on which the first electrode layer 210a, 210b, 310a, 310b, 310b', 310c, 310c', 310d, 410a, 410b, 410c, 510a, 510b and 510c is not formed.

A second electrode layer 240a, 240b, 240c, 330a, 330b, 330b', 330c, 330c', 330d, 430a, 430a', 430b, 430b', 430c, 530a, 530b and 530c is formed by obliquely emitting a second conductive material so that the second conductive material is deposited on the solar cell layer 230, 320, 420 and 520.

The solar cell layer 230, 320, 420 and 520 formed on the trenches 205a, 205b, 305a, 305c, 305e, 405, 406, 505a and 505b is etched such that the first electrode layer 210a, 210b, 310a, 310b, 310b', 310c, 310c', 310d, 410a, 410b, 410c, 510a, 510b and 510c is exposed.

A conductive layer 250a, 250b, 250c, 340a, 340b, 340b', 340c, 340c', 340d, 450a, 450b, 450c, 540a, 540b and 540c is formed by obliquely emitting a third conductive material and depositing the third conductive material on the second electrode layer 240a, 240b, 240c, 330a, 330b, 330b', 330c, 330c', 330d, 430a, 430a', 430b, 430b', 430c, 530a, 530b and 530c such that the exposed first electrode layer 210a, 210b, 310a, 310b, 310b', 310c, 310c', 310d, 410a, 410b, 410c, 510a, 510b and 510c is electrically connected to the second electrode layer 240a, 240b, 240c, 330a, 330b, 330b', 330c, 330c', 330d, 430a, 430a', 430b, 430b', 430c, 530a, 530b and 530c.

An integrated thin-film solar cell according to the embodiment of the present invention includes a substrate 200, 300, 400 and 500, a first electrode layer 210a, 210b, 310a, 310b, 310b', 310c, 310c', 310d, 410a, 410b, 410c, 510a, 510b and 510c, a solar cell layer 230, 320, 420 and 520, a second electrode layer 240a, 240b, 240c, 330a, 330b, 330b', 330c, 330c', 330d, 430a, 430a', 430b, 430b', 430c, 530a, 530b and 530c, and a conductive layer 250a, 250b, 250c, 340a, 340b, 340b', 340c, 340c', 340d, 450a, 450b, 450c, 540a, 540b and 540c.

Trenches 205a, 205b, 305a, 305c, 305e, 405, 406, 505a and 505b are formed separately from each other by a predetermined interval on the substrate 200, 300, 400 and 500.

The first electrode layer 210a, 210b, 310a, 310b, 310b', 310c, 310c', 310d, 410a, 410b, 410c, 510a, 510b and 510c is formed on the portion of the bottom side of and one side of each of the trenches 205a, 205b, 305a, 305c, 305e, 405, 406, 505a and 505b.

The solar cell layer 230, 320, 420 and 520 is formed on the substrate 200, 300, 400 and 500 and on the first electrode layer 210a, 210b, 310a, 310b, 310b', 310c, 310c', 310d, 410a, 410b, 410c, 510a, 510b and 510c such that the portion of the first electrode layer 210a, 210b, 310a, 310b, 310b', 310c, 310c', 310d, 410a, 410b, 410c, 510a, 510b and 510c is exposed.

The second electrode layer 240a, 240b, 240c, 330a, 330b, 330b', 330c, 330c', 330d, 430a, 430a', 430b, 430b', 430c, 530a, 530b and 530c is formed on the solar cell layer 230, 320, 420 and 520.

The conductive layer 250a, 250b, 250c, 340a, 340b, 340b', 340c, 340c', 340d, 450a, 450b, 450c, 540a, 540b and 540c is formed on the second electrode layer 240a, 240b, 240c, 330a, 330b, 330b', 330c, 330c', 330d, 430a, 430a', 430b, 430b', 430c, 530a, 530b and 530c such that the exposed first electrode layer 210a, 210b, 310a, 310b, 310b', 310c, 310c', 310d, 410a, 410b, 410c, 510a, 510b and 510c is electrically connected to the second electrode layer 240a, 240b, 240c, 330a, 330b, 330b', 330c, 330c', 330d, 430a, 430a', 430b, 430b', 430c, 530a, 530b and 530c.

Next, a method of manufacturing an integrated thin-film solar cell according to the embodiment of the present invention will be described in detail with reference to the drawings.

### [First embodiment]

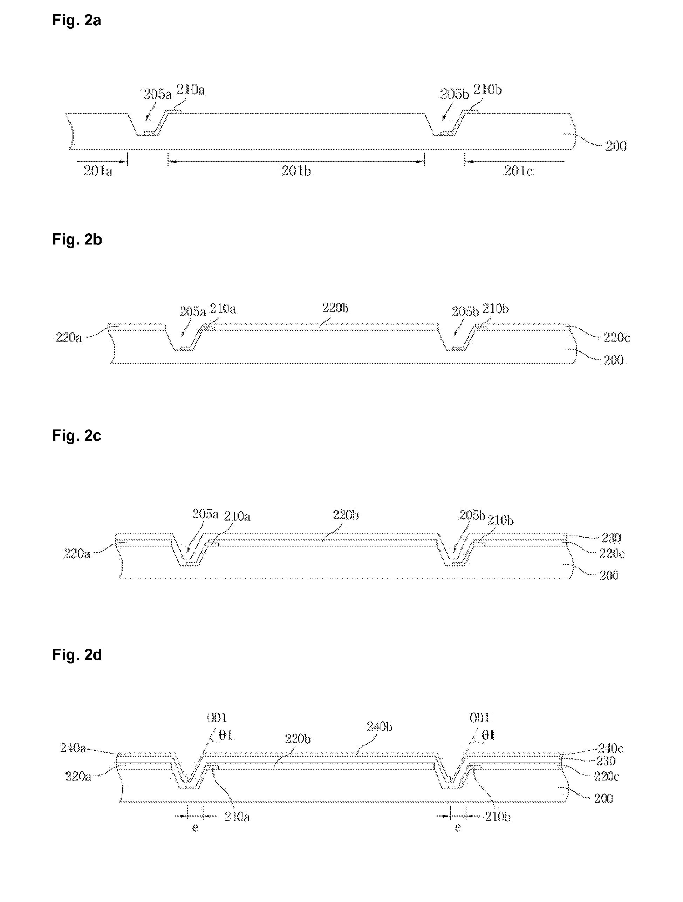

Figs. 2a to 2k show a manufacturing method of an integrated thin-film solar cell according to a first embodiment of the present invention.

Referring to Figs. 2a to 2k, unit cell areas 201a, 201b and 201c are between trenches 205a and 205b of a substrate 200. First electrode layers 210a and 210b, separate electrode layers 220a, 220b and 220c, solar cell layers 230a, 230b and 230c, second electrode layers 240a, 240b and 240c, conductive layers 250a, 250b and 250c and a conductive paste of a bus bar area are formed on the substrate 200.

Referring to Fig. 2a, the trenches 205a and 205b are formed separately from each other by a predetermined interval on the substrate 200 such that the unit cell areas 201a, 201b and 201c are defined. The substrate 200 functions as a main body constituting an integrated thin-film solar cell. Light is first incident on the substrate 200. Therefore, it is desirable that the substrate 200 is made of a transparent insulating material having an excellent light transmittance. For example, the substrate 200 is made of one selected from among a soda lime glass, a general glass and a tempered glass. Further, the substrate 200 may be a polymer material substrate or a nano composite material substrate. The nano composite is a system in which nano particles as a dispersoid are distributed in a dispersion medium having a continuous phase. The dispersion medium may be formed of a polymer, a metallic material or a ceramic material. The nano particle may be formed of a polymer, a metallic material or a ceramic material.

The trenches 205a and 205b are formed on the substrate 200. The unit cell areas 201a, 201b and 201c are defined by the trenches 205a and 205b. Unit cells are formed on the unit cell areas 201a, 201b and 201c by the subsequent process. Under the condition that the glass substrate, the polymer substrate or the nano composite substrate and the like are molten, the trenches are formed in a strip form by using an embossing process before the glass substrate, the polymer substrate or the nano composite substrate and the like are hardened. Moreover, the trenches 205a and 205b can be formed on the substrates by using a hot-embossing method without melting the substrates.

The substrate 200 may include a glass material and a polymer material thin-film coated on the glass material or may include a glass material and a nano composite material thin-film coated on the glass material. In this case, the trenches are formed in the polymer material thin-film or the nano composite material thin-film by use of the hot-embossing method. Additionally, during the process in which the polymer material thin-film or the nano composite material thin-film is coated on the glass material, the trenches are formed in the polymer material thin-film or the nano composite material thin-film through use of the embossing method. Here, the polymer material or the nano composite material may include a thermosetting material or an UV thermosetting material.

Since the trench is formed in the polymer material thin-film coated on the glass or in the nano composite material thin-film coated on the glass, it is easier to form the trench in the polymer material thin-film or the nano composite material thin-film than to directly form the trench in the glass.

The trenches 205a and 205b can be formed not only by the embossing method or the hot-embossing method but also by one of a wet etching process, a dry etching process, a mechanical process or an optical process using a laser.

The foregoing materials of the substrate and the method of forming the trench can be commonly applied to the following description of a second embodiment to a fourth embodiment.

Referring to Fig. 2a, the first electrode layers 210a and 210b are formed of a first conductive material on a certain area of each of the trenches 205a and 205b and on a certain area of each of the unit cell areas 201a, 201b and 201c adjacent to the trenches 205a and 205b. The certain area of each of the trenches 205a and 205b may include, as shown in Fig. 2a, a bottom side and one side of each trench.

In the first embodiment, the first electrode layers 210a and 210b are formed to be electrically connected in series to an adjacent unit cell and formed to efficiently transfer current generated by a unit cell to another adjacent unit cell. A transparent electrode material used for later forming a separate electrode layer has an electrical resistance greater than that of a metallic material. The current generated by the unit cell is inefficiently transferred by such a transparent electrode material, so that the overall efficiency of the thin-film solar cell may be reduced. In order to prevent the efficiency of the thin-film solar cell from being reduced, the first electrode layer can be formed of a metallic material having less electrical resistance than that of the transparent electrode material constituting the separate electrode layer.

Therefore, in the first embodiment of the present invention, at least one of Al, Ag, Zn or Cr is included in the first conductive material used for forming the first electrode layers 210a and 210b. The first electrode layers 210a and 210b can be formed by using any one of deposition method using a metal mask, an ink jet method, a jet spray method, a screen printing method, a nano imprint method or a stamping method.

Referring to Fig. 2b, separate electrode layers 220a, 220b and 220c different from the first electrode layers 210a and 210b are formed on the unit cell areas 201a, 201b and 201c.

The separate electrode layers 220a, 220b and 220c are formed of a transparent conductive material such that sunlight is incident on a solar cell layer through the substrate 200. The separate electrode layers 220a, 220b and 220c are hereby formed of at least one of zinc oxide (ZnO), tin oxide (SnO2) or indium tin oxide (ITO).

The separate electrode layers 220a, 220b and 220c may be formed by the following process. Through use of a printing method in which a sol-gel solution including a material for forming the separate electrode layers 220a, 220b and 220c is used like an ink, the separate electrode layers 220a, 220b and 220c are formed by directly applying the sol-gel solution on the unit cell areas 201a, 201b and 201c by using a printing method without using a polymer pattern or a photo resistor method which uses a mask. In this case, while the sol-gel solution can be directly applied on the unit cell areas 201a, 201b and 201c by using a roller and the like, a method of applying the sol-gel is not limited to this. Meanwhile, since the separate electrode layers formed by the printing method may have high electrical resistance, the separate electrode layers may be heat treated in the gas atmosphere such as air or nitrogen.

Such a method makes it possible to directly form the separate electrode layers 220a, 220b and 220c patterned in the form of a band without an etching process according to a mask work. As such, the printing method used for forming the separate electrode layers 220a, 220b and 220c has a relatively simple process and does not require an expensive laser patterning equipment used by existing processes, thereby reducing the manufacturing cost.

Referring to Fig. 2c, a solar cell layer 230 is formed on the first electrode layers 210a and 210b, on the separate electrode layers 220a, 220b and 220c and on the portions of the trenches 205a and 205b on which the first electrode layers 210a and 210b are not formed.

The solar cell layer 230 is made of a photovoltaic material. The solar cell layer 230 is made of an arbitrary material generating electric current from the incidence of sunlight. For example, the solar cell layer 230 is made of at least one of a silicon based photovoltaic material, a compound based photovoltaic material, an organic based photovoltaic material and a dry dye sensitized based photovoltaic material. Here, a silicon based solar cell includes an amorphous silicon(a-Si:H) single junction solar cell, an a-Si:H/a-Si:H, a-Si:H/a-Si:H/a-Si:H multi-junction solar cell, an amorphous silicon-germanium(a-SiGe:H) single junction solar cell, an a-Si:H/a-SiGe:H double junction solar cell, an a-Si:H/a-SiGe:H/a-SiGe:H triple junction solar cell and an amorphous silicon/microcrystalline(poly) silicon double junction solar cell.

The solar cell layer of the first embodiment can be commonly applied to a second embodiment to a fourth embodiment.

Referring to Fig. 2d, a second conductive material is obliquely emitted (OD1) and the second conductive material is deposited on the solar cell layer 230. As a result, second electrode layers 240a, 240b and 240c are formed.

As shown in Fig. 2d, the second conductive material is obliquely emitted (OD1) at an angle of θ1 on the substrate 200 on which the solar cell layer 230 and the trenches 205a and 205b are formed. In this case, deposition straightness causes the second conductive material to be deposited on the solar cell layer 230. Due to the angle of θ1 and the trenches 205a and 205b formed on the substrate 200, the second conductive material is not deposited on a portion "e" of the solar cell layer 230 formed on the trenches 205a and 205b. In this case, a deposition method such as an electron beam deposition or a thermal deposition and the like is used, and there is no limit to the deposition method.

Based on the aforementioned method, the self-aligned second electrode layers 240a, 240b and 240c are formed of the second conductive material. The second conductive material may include at least one of a transparent conductive material, Al, Ag, Zn or Cr. Here, the transparent conductive material may include ZnO, SnO₂ or ITO. The components of the second conductive material can be applied to the second embodiment to the fourth embodiment.

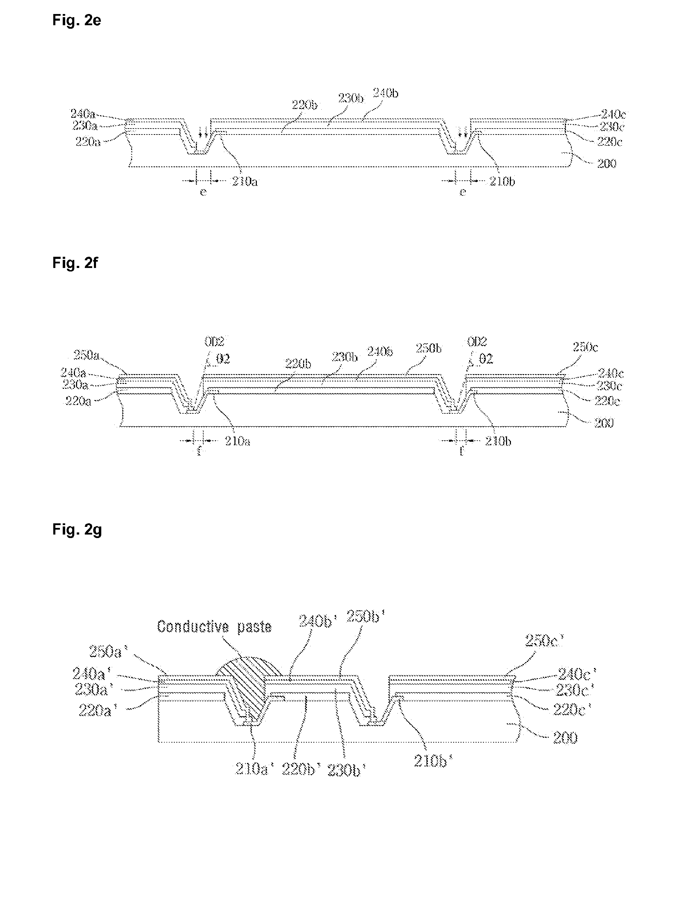

Referring to Fig. 2e, the solar cell layer 230 formed on the trenches 205a and 205b is etched such that the first electrodes 210a and 210b are exposed.

Here, the solar cell layer 230 is actually vertically etched by using the second electrode layers 240a, 240b and 240c as a mask. Here, an etching process is performed on the portion "e" of the solar cell layer 230 on which the second electrode layers 240a, 240b and 240c are not formed. However, it is desired that a dry etching process such as a reactive ion etching (RIE) method and the like, there is no limit to the etching process.

As such, since the solar cell layer 230 can be etched by the self-aligned second electrode layers 240a, 240b and 240c without a mask, it is possible to create an insulation gap of from several µm to several ten µm between the unit cells. As compared with both an existing plasma chemical vaporization machining and an existing laser patterning using a laser beam, the insulation gap can be reduced to from a several tenths to a several hundredths of existing insulation gap formed through the aforementioned etching processes. Therefore, it is possible to maximize the effective area of the thin-film solar cell. Meanwhile, solar cell layer patterns 230a, 230b and 230c are formed on the unit cell areas by etching the solar cell layer 230 through use of the aforementioned method. Through the etching process of the solar cell layer 230, the first electrode layers 210a and 210b formed on the trenches 205a and 205b are exposed.

Such an etching method can be commonly applied to a second embodiment to a fourth embodiment.

Referring to Fig. 2f, a third conductive material is obliquely deposited (OD2) on the second electrode layer 240a such that the first electrode layer 210a connected to the separate electrode layer 220b formed on one unit cell area (for example, 201b) is electrically connected to the second electrode layer 240a formed on another unit cell area (for example, 201a) adjacent to the unit cell area 201b. As a result, a conductive layer 250a is formed. The conductive layer 250a is hereby connected to the first electrode layer 210a in the trench.

When a predetermined insulation gap is formed between the unit cells by the etching process, the third conductive material can be deposited by using the same deposition method as that of the second conductive material. That is, when the third conductive material is obliquely deposited (OD2) at an angle of θ2 by using an electron beam or a thermal deposition apparatus, deposition straightness causes the third conductive material to be deposited on the other portion except a portion "f" of the first electrode layer 210a exposed by etching. As a result, the conductive layers 250a, 250b and 250c are formed. Here, the third conductive material includes at least one of a transparent conductive material, Al, Ag, Zn or Cr. The transparent conductive material includes ZnO, SnO₂ or ITO. The components of the third conductive material can be commonly applied to the second embodiment to the fourth embodiment.

The formed conductive layers 250a, 250b and 250c allow the first electrode layer 210a connected to the separate electrode layer 220b formed on one unit cell area (for example, 201b) to be electrically connected to the second electrode layer 240a formed on another unit cell area (for example, 201a) adjacent to the unit cell area. Accordingly, the unit cells 201a and 201b are electrically connected in series to each other.

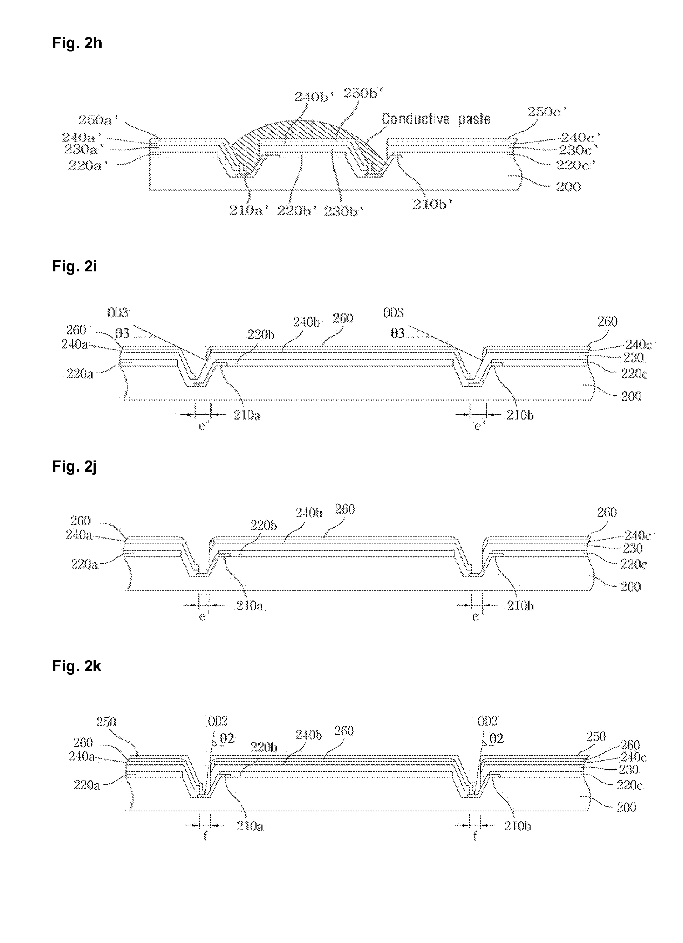

Referring to Figs. 2g and 2h, a bus bar area is formed by burying a conductive paste in at least one trench located at a certain area of the substrate of the integrated thin-film solar cell. Here, as shown in Fig. 2h, when the conductive paste is buried in a plurality of the trenches, an interval between the trenches on which the conductive paste is buried may be less than an interval between the trenches belonging to a solar cell area instead of belonging to the bus bar area. In other words, since the bus bar area does not generate electricity, the interval between the trenches of the bus bar area may be less than the interval between the trenches of the solar cell area generating electricity. The property of the bus bar area can be commonly applied to the following description of a second embodiment to a fourth embodiment.

In the first embodiment of the present invention, an area between an outermost trench of the substrate and a trench adjacent to the outermost trench corresponds to a bus bar area. The bus bar area may be between 3mm and 5mm. The aforementioned process of Figs. 2a to 2f is applied to the trenches of the bus bar area.

After the conductive paste is buried in the trenches of the bus bar area, a bus bar (not shown) such as a conductive tape is adhered on the conductive paste, so that electric current generated from the solar cell layer flows to the outside through the bus bar.

Such a bus bar supplies efficiently the electric power generated from the integrated thin-film solar cell to the outside. Since the bus bar area may be variable depending on the number of the trenches, it is possible to apply various width of the bus bar and to increase the adhesive strength between the bus bar and the conductive paste.

The conductive paste includes at least one of Al, Ag, Au, Cu, Zn, Ni or Cr. A printing method, an ink jet method, a jet spray method, a screen printing method, a nano imprint method or a stamping method and the like is used as a burying method of the conductive paste.

Such a method makes it possible to directly form a patterned bus bar area at a low temperature without an etching process according to a mask work. The method of the embodiment has a simple process and does not require expensive equipments, thereby reducing the manufacturing cost. When the bus bar area is formed according to the embodiment, a laser pattering process is not separately required for forming the bus bar. Therefore it is possible to rapidly and simply form the bus bar area.

Meanwhile, after the second electrode layers 240a, 240b and 240c are formed according to the process shown in Fig. 2d, a short-circuit prevention layer 260 may be formed for preventing the short-circuits of the electrode layers before the solar cell layer 230 is etched. That is, as shown in Figs. 2d to 2e, the etching is performed by the self-aligned second electrode layers 240a, 240b and 240c, there may occur a short-circuit between the ends of the second electrode layers 240a, 240b and 240c and the first electrode layers 210a and 210b or between the second electrode layers 240a, 240b and 240c and the separate electrode layers 220a, 220b and 220c.

In order to prevent the short-circuit, as shown in Fig. 2i, a short-circuit prevention material is emitted obliquely at an angle of θ3 from the opposite side to one side from which the second conductive material of Fig. 2d is emitted so that the short-circuit prevention material is deposited on the solar cell layer 230 and the second electrode layers 240a, 240b and 240c. Subsequently, as shown in Fig. 2j, the solar cell layer 230 is etched such that the first electrode layers 210a and 210b are exposed by the self-aligned second electrode layers 240a, 240b and 240c and the short-circuit prevention layer.

Here, since the etched area " e' " is less than the etched area "e" of Fig. 2d and the short-circuit prevention layer 260 covers the ends of the second electrode layers 240a, 240b and 240c, it is possible to prevent the short-circuit between the ends of the second electrode layers 240a, 240b and 240c and the first electrode layers 210a and 210b or between the second electrode layers 240a, 240b and 240c and the separate electrode layers 220a, 220b and 220c. The short-circuit prevention layer 260 may be formed of the same material as that of the second electrode layers 240a, 240b and 240c.

As shown in Fig. 2k, the third conductive material is obliquely emitted and deposited. As a result, the conductive layers 250a, 250b and 250c are formed. Since the conductive layers 250a, 250b and 250c of Fig. 2j and forming process thereof have been described in Fig. 2f, the description thereof will be omitted.

The short-circuit prevention layer 260 can be applied to the following second embodiment to a fourth embodiment.

### [Second embodiment]

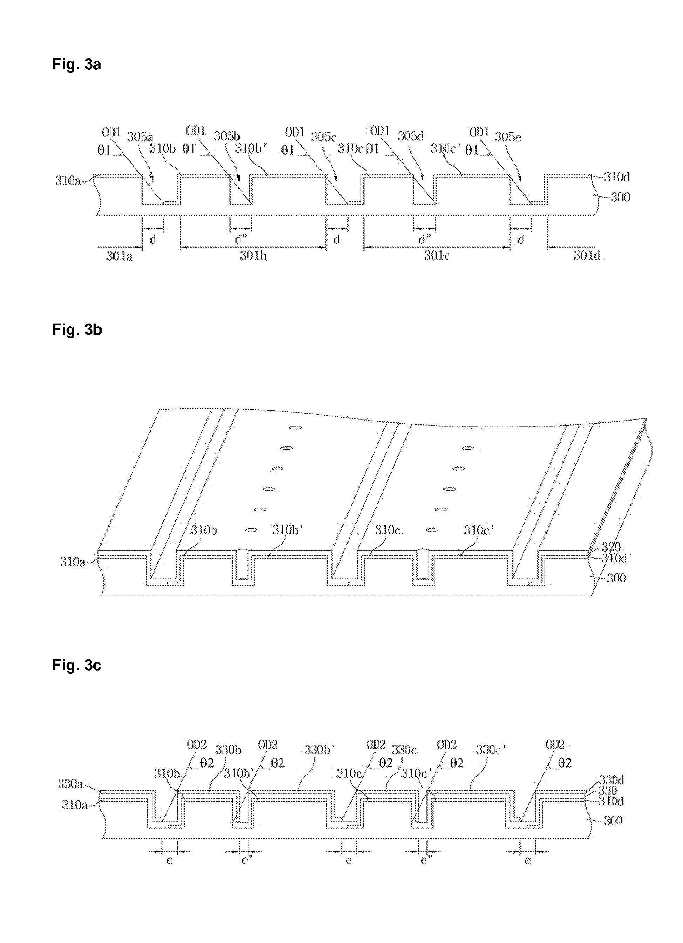

Figs. 3a to 3g show a manufacturing method of an integrated thin-film solar cell according to a second embodiment of the present invention.

Referring to Figs. 3a to 3g, unit cell areas 301a, 301b and 301c are between trenches 305a, 305c and 305e of a substrate 300. Grooves 305b and 305d, first electrode layers 310a, 310b, 310c and 310d, a solar cell layer 320, second electrode layers 330a, 330b and 330c, conductive layers 340a, 340b and 340c and a conductive paste 350 of a bus bar area are formed on the substrate 300. Though not shown, a plurality of the grooves 305b and 305d are formed in a predetermined area of each of the unit cell areas 301a, 301b and 301c.

Referring to Fig. 3a, trenches 305a, 305c and 305e are formed separately from each other by a predetermined interval on a substrate 300 such that unit cell areas 301a, 301b and 301c are defined. Grooves 305b and 305d are formed on the substrate 300 both between the adjacent trenches 305a and 305c and between the adjacent trenches 305c and 305e.

The grooves 305b and 305d are formed in a predetermined area of each of the unit cell areas 301a, 301b and 301c. The grooves 305b and 305d are areas through which sunlight transmits by the subsequent process. Meanwhile, the grooves 305b and 305d can be formed by the same forming method as that of the trenches of the aforementioned first embodiment.

In the second embodiment of the present invention, the substrate 300 on which the trenches 305a, 305c and 305e and the grooves 305b and 305d have been already formed can be used. A process of forming the trenches 305a, 305c and 305e and the grooves 305b and 305d on the substrate 300 can be included in the second embodiment. Also, the trenches 305a, 305c and 305e and the grooves 305b and 305d can be simultaneously formed.

As shown in Fig. 3a, the widths of the grooves 305b and 305d are formed to be less than those of the trenches 305a, 305c and 305e, and the depths of the grooves 305b and 305d are formed to be equal to those of the trenches 305a, 305c and 305e. Though not shown, the depths of the grooves 305b and 305d can be formed to be greater than those of the trenches 305a, 305c and 305e, and the widths of the grooves 305b and 305d can be formed to be equal to those of the trenches 305a, 305c and 305e. This intends that a subsequent first, second and third conductive materials are obliquely deposited in order that the first, second and third conductive materials are not deposited on the bottom surfaces of the grooves 305b and 305d. As a result, it is not necessary to perform an etching process for removing the first, second and third conductive materials on the bottom surfaces of the grooves 305b and 305d. Thus, in the subsequent process, when only the solar cell layer formed on the bottom surfaces of the grooves 305b and 305d are etched, light is able to transmit through the bottom surfaces of the grooves 305b and 305d.

Referring to Fig. 3a, a first conductive material is obliquely emitted from one side (OD1) so that the first conductive material is deposited on a portion of the bottom side of and one side of each of the trenches 305a, 305c and 305e of the substrate 300 having the unit cell areas 301a, 301b and 301c formed therein. As a result, first electrode layers 310a, 310b, 310b', 310c, 310c' and 310d are formed. Unlike the first electrode layers 210a and 210b of the first embodiment, the first electrode layers 310a, 310b, 310b', 310c, 310c' and 310d of the second embodiment are formed on the substrate surfaces adjacent to the trenches. Separate electrode layers 220a, 220b and 220c of the first embodiment may not be hereby formed.

When the first conductive material is obliquely emitted (OD1) at an angle of θ1, deposition straightness causes the first conductive material to be deposited on the substrate 300. As a result, the first electrode layers 310a, 310b, 310b', 310c, 310c' and 310d are formed. Due to the angle of θ1, trenches 305a, 305c and 305e formed on the substrate 300 and the grooves 305b and 305d, the first conductive material is not deposited on a portion "d" of the trenches 305a, 305c and 305e and on the bottom surfaces " d" " of the grooves 305b and 305d. In this case, a deposition method such as an electron beam deposition or a thermal deposition and the like is used, and there is no limit to the deposition method.

The grooves 305b and 305d formed in the unit cell areas 301b have a circular, polygonal or elliptical shape and are uniformly distributed on the unit cell area.

Here, the first conductive material includes at least one of ZnO, SnO₂ or ITO.

Referring to Fig. 3b, the solar cell layer 320 is formed on the portions of the trenches 305a, 305c and 305e on which the first electrode layers 310a, 310b, 310c and 310d are not formed, on the portions of the grooves 305b and 305d on which the first electrode layers 310a, 310b, 310c and 310d are not formed, and on the first electrode layers 310a, 310b, 310b', 310c, 310c' and 310d.

The solar cell layer 320 is made of a photovoltaic material. The solar cell layer 320 is made of an arbitrary material generating electric current from the incidence of sunlight.

Referring to Fig. 3c, a second conductive material is obliquely emitted at an angle of θ2 from the opposite side to the one side so that the second conductive material is deposited on the solar cell layer 320. As a result, second electrode layers 330a, 330b and 330c are formed.

Due to the angle of θ2 and the trenches 305a, 305c and 305e formed on the substrate 300, a second conductive material is not formed on a portion "e" of the solar cell layer 320 formed on the trenches 305a, 305c and 305e. In this case, a deposition method such as an electron beam deposition or a thermal deposition and the like is used, and there is no limit to the deposition method. Meanwhile, the portion "e" on which the second conductive material is not formed is etched in the subsequent process. The second conductive material is not deposited on the solar cell layer 320 " e" " formed on the bottom surfaces of the grooves 305b and 305d.

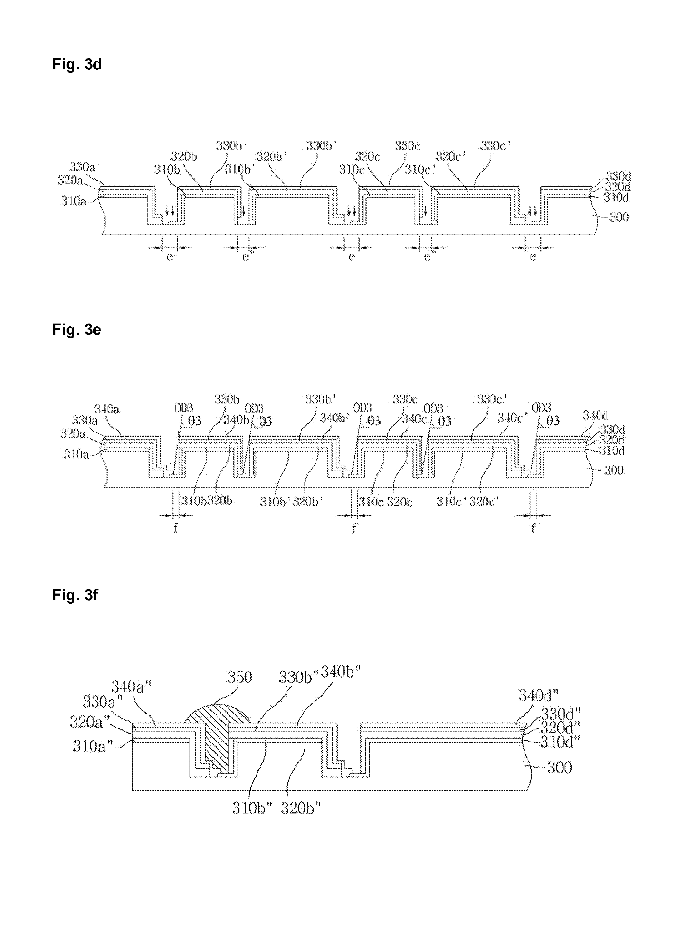

Referring to Fig. 3d, the solar cell layer 320 formed on the trenches 305a, 305c and 305e is etched such that the first electrodes 310a, 310b, 310c, and 310d are exposed. The solar cell layer 320 formed on the grooves 305b and 305d is also etched such that light transmits through the grooves 305b and 305d. That is, the bottom surfaces " e" " of the grooves 305b and 305d are exposed so that light is able to transmit through the bottom surfaces " e" " of the grooves 305b and 305d.

Here, the solar cell layer 320 is actually vertically etched by using the second electrode layers 330a, 330b and 330c as a mask. Here, an etching process is performed on the portion "e" of the solar cell layer 320 on which the second conductive material are not formed and performed on the solar cell layer 320 formed on the bottom surfaces " e" " of the grooves 305b and 305d on which the second conductive material are not deposited. Thus, since the self-aligned second electrode layers 330a, 330b and 330c are used as a mask, a separate mask is not required.

Meanwhile, solar cell layer patterns 320a, 320b and 320c are formed on the unit cell areas by etching the solar cell layer 320 through use of the aforementioned method. Through the etching process of the solar cell layer 320, the first electrode layers 310a, 310b, 310c and 310d formed on the trenches 305a, 305c and 305e are exposed. The bottom surfaces " e" " of the grooves 305b and 305d are also exposed. The solar cell layer formed on the trenches 305a, 305c and 305e and the solar cell layer formed on the grooves 305b and 305d can be simultaneously etched.

Referring to Fig. 3e, a third conductive material is obliquely emitted and deposited (OD3) on the second electrode layer (for example, 330a) such that the first electrode layer 310b formed on one unit cell area (for example, 301b) and the second electrode layer 330a formed on another unit cell area (for example, 301a) adjacent to the unit cell area 301b are electrically connected to each other at the trench (for example, 305a) between the adjacent unit cell areas (for example, 301b and 301a). As a result, conductive layers 340a, 340b, 340b', 340c and 340d are formed. The first electrode layer (for example, 310b) in the trench (for example, 305a) is hereby connected to the conductive layer (for example, 340a).

When a predetermined insulation gap is formed between the unit cells by the etching process, the third conductive material can be deposited by using the same deposition method as that of the second conductive material. That is, when the third conductive material is obliquely emitted (OD3) at an angle of θ3 by using an electron beam or a thermal evaporator, deposition straightness causes the third conductive material to be deposited on the other portion except a portion "f" of the first electrode layers 310a, 310b, 310c and 310d exposed by etching. As a result, the conductive layers 340a, 340b, 340b', 340c, 340c' and 340d are formed. Here, as described above, the third conductive material is not deposited on the bottom surfaces of the groove 305b and 305d.

The formed conductive layers 340a, 340b, 340b', 340c, 340c' and 340d allow the first electrode layer 310b formed on one unit cell area (for example, 301b) to be electrically connected to the second electrode layer 330a formed on another unit cell area (for example, 301a) adjacent to the unit cell area 301b. The unit cells are electrically connected in series to each other.

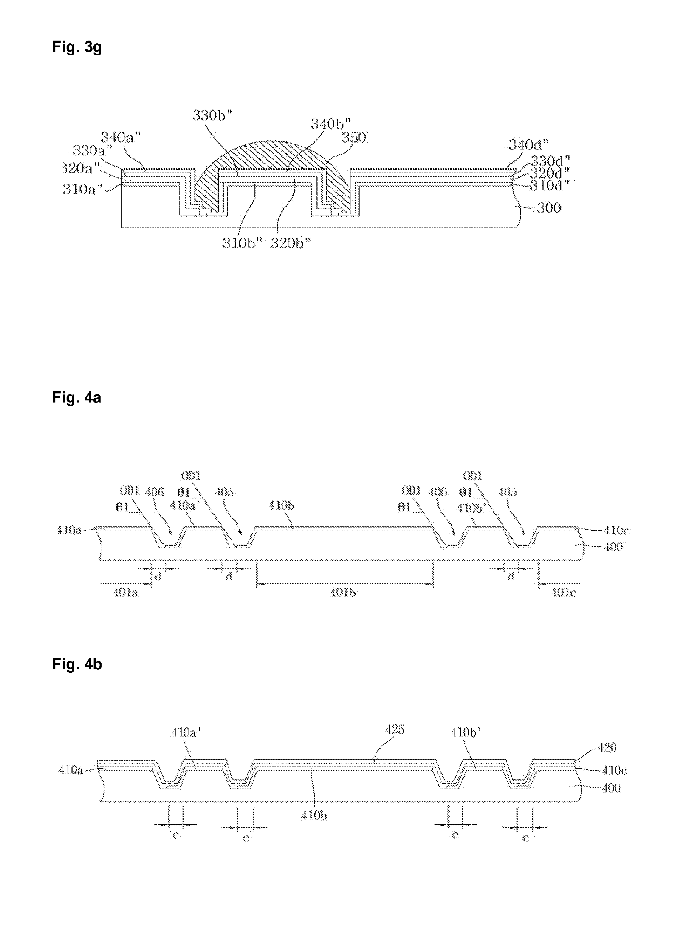

Referring to Figs. 3f and 3g, a bus bar area is formed by burying a conductive paste 350 in both trenches formed in ends of the substrate of the integrated thin-film solar cell and in trenches adjacent thereto. As the bus bar area and the conductive paste have been described in the first embodiment, the detailed description thereof will be omitted.

The processes of the second embodiment are performed according to self-alignment without a position control device, thereby manufacturing the integrated thin-film solar cell through a relatively simple process. The embodiment of the present invention provides a see-through type integrated thin-film solar cell. In the embodiment, if a transparent polymer or transparent nano composite material is used as a material of the substrate 300, it is possible to manufacture a flexible integrated thin-film solar cell which can be applied to the window of a house or a car.

### [Third embodiment]

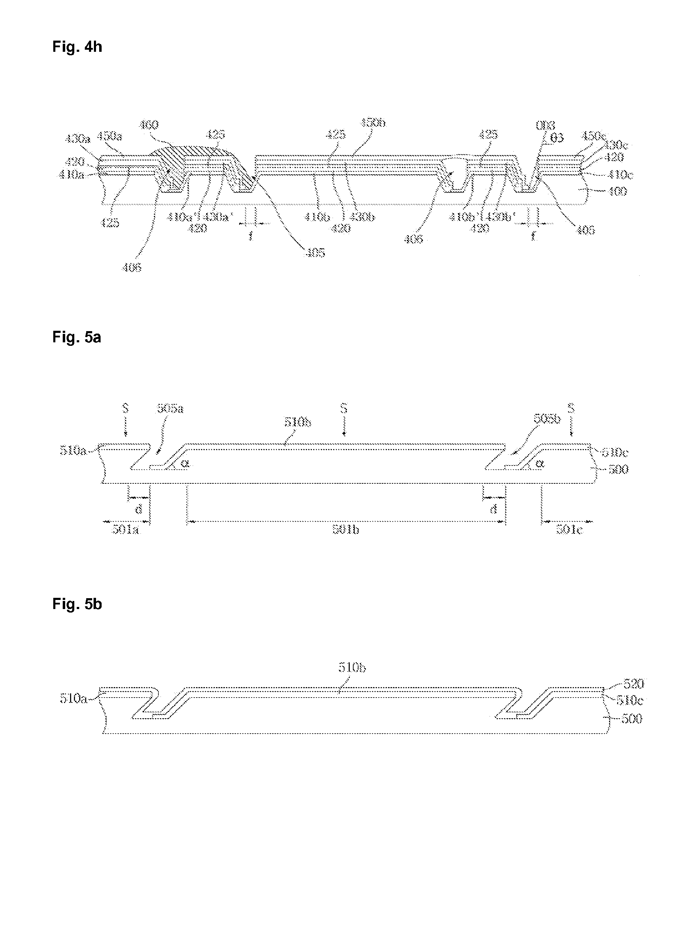

Figs. 4a to 4h show a manufacturing method of an integrated thin-film solar cell according to a third embodiment of the present invention.

Referring to Figs. 4a to 4h, trenches 405 and 406 are formed on a substrate 400. Unit cell areas 401a, 401b and 401c are defined by the trench 405 among the trenches 405 and 406. The trench 405 performs the same function as those of the trenches of the first and the second embodiments. The trench 406 is formed on a predetermined area of each of the unit cell areas 401a, 401b and 401c. Further, first electrode layers 410a, 410a', 410b, 410b' and 410c, a solar cell layer 420, an intermediate layer 425, second electrode layers 430a, 430a', 430b, 430b' and 430c, an insulation material 440 and conductive layers 450a, 450a', 450b, 450b' and 450c are formed on the substrate 400.

Referring to Fig. 4a, the trenches 405 and 406 are formed separately from each other by a predetermined interval on the substrate 400 such that the unit cell areas 401a, 401b and 401c are defined. A plurality of the trenches 405 are formed on the substrate 400 so as to define the unit cell areas 401a, 401b and 401c. Unit cells are formed on the unit cell areas 401a, 401b and 401c by the subsequent process. The trench 406 is formed on a predetermined area of each of the unit cell areas 401a, 401b and 401c, and then the insulation material is buried in the trench 406 in the subsequent process.

Referring to Fig. 4a, a first conductive material is obliquely emitted (OD1) so that the first conductive material is deposited on a portion of the bottom surface and one side of each of the trenches 405 and 406 of the substrate 400. As a result, a first electrode layers 410a, 410a', 410b, 410b' and 410c are formed.

As shown in Fig. 4a, the first conductive material is obliquely emitted (OD1) at an angle of θ1 on the substrate 400 having the trenches 405 and 406 formed therein. Therefore, deposition straightness causes the first conductive material not to be deposited on a portion "d" of the trenches 405 and 406. The first conductive material is deposited by using an electron beam deposition or a thermal deposition and the like. The deposition method is not limited to this.

According to the aforementioned method, the first electrode layers 410a, 410a', 410b, 410b' and 410c are formed by depositing the first conductive material. In one unit cell area, the first electrode layer is divided into two portions (e.g., 410a and 410a' or 410b and 410b') by the trench 406. Here, the first conductive material includes at least one of ZnO, SnO2 or ITO.

Referring to Fig. 4b, a solar cell layer 420 is formed on the first electrode layers 410a, 410a', 410b, 410b' and 410c and on the portions of the trenches 405 and 406 on which the first electrode layers 410a, 410a', 410b, 410b' and 410c are not formed. The solar cell layer 420 is made of a photovoltaic material. The solar cell layer 420 is made of an arbitrary material generating electric current from the incidence of sunlight.

In the case of a multi junction cell, for the purpose of the efficiency improvement of a thin-film solar cell, an intermediate layer 425 is formed in the boundary of individual cell constituting the multi junction cell. The intermediate layer 425 is made of a conductive material. For example, the intermediate layer 425 includes one of metal oxide, silicon nitride, silicon oxide, silicon carbide and transparent conductive oxide. The transparent conductive oxide includes at least one of ZnO, SnO2 or ITO.

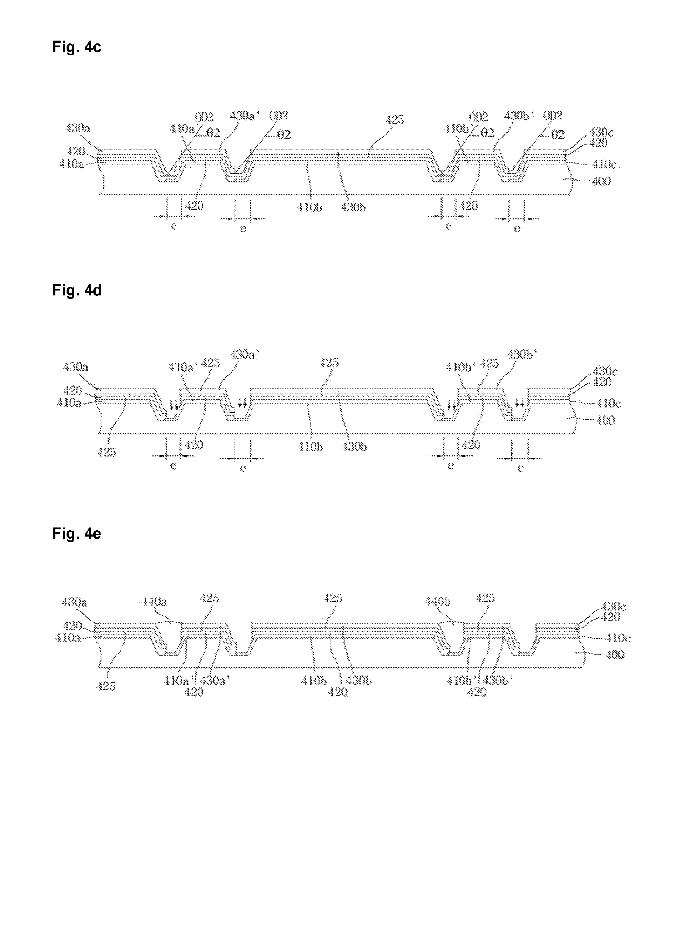

Referring to Fig. 4c, a second conductive material is obliquely emitted at an angle of θ2 so that the second conductive material is deposited on the solar cell 420. As a result, second electrode layers 430a, 430a', 430b, 430b' and 430c are formed. When the second conductive material is obliquely deposited, deposition straightness causes the second conductive material not to be deposited on a portion "e" of the solar cell layer 420 formed on the trenches 405 and 406. In this case, a deposition method such as an electron beam deposition or a thermal evaporation and the like is used, and there is no limit to the deposition method. Based on the described method, the self-aligned second electrode layers 430a, 430a', 430b, 430b' and 430c are formed of the second conductive material. Meanwhile, the portion "e" of the solar cell layer 420 is etched in the subsequent process.

Referring to Fig. 4d, the solar cell layer 420 formed on the trenches 405 and 406 is etched such that the first electrodes 410a, 410a', 410b, 410b' and 410c are exposed. Here, the solar cell layer 420 is actually vertically etched by using the second electrode layers 430a, 430a' and 430b as a mask. Here, an etching process is performed on the portion "e" of the solar cell layer 420 having no second conductive material formed thereon.

Meanwhile, solar cell layer patterns are formed on the unit cell areas by etching the solar cell layer 420 through use of the aforementioned method. Through the etching process of the solar cell layer 420, the first electrode layers 410a, 410a', 410b, 410b' and 410c formed on the trenches 405 and 406 are exposed.

Referring to Fig. 4e, an insulation material 440 is buried in the trenches 406 adjacent to the trench 405. Here, the insulation material 440 includes aluminum oxide, silicon oxide, enamel or a material mixed with them. The insulation material 440 is buried on the trench 406 by using a printing method, an ink jet method, a jet spray method, a screen printing method, a nano imprint method or a stamping method and the like. The reason why the insulation material 440 is buried on the trench 406 will be described later in detail.

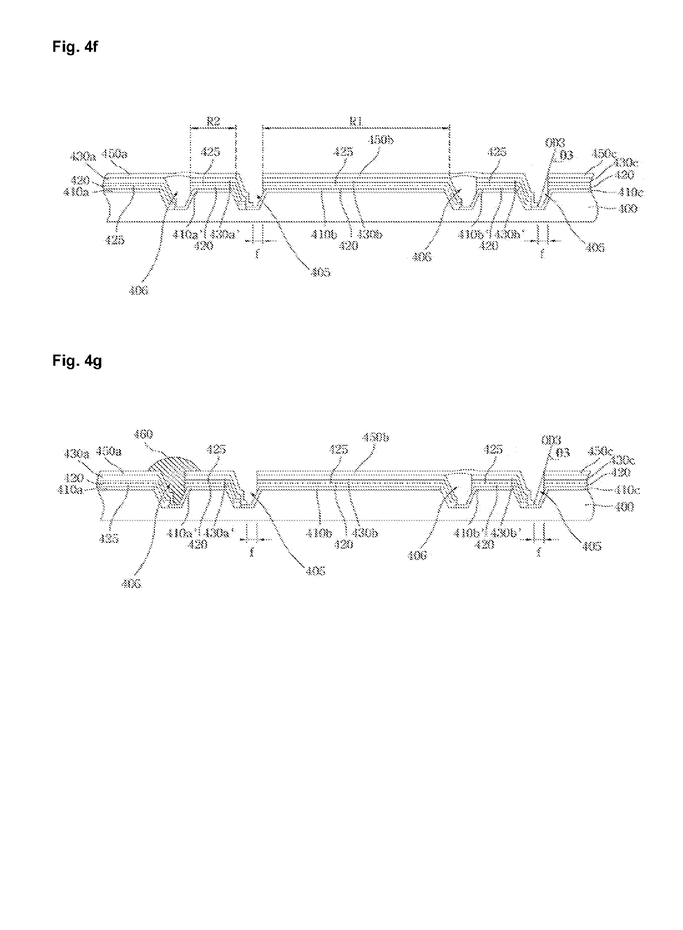

Referring to Fig. 4f, a third conductive material is obliquely emitted (OD3) so that the third conductive material is deposited on the second electrode layer 430a, 430a', 430b, 430b' and 430c. As a result, conductive layers 450a, 450b and 450c are formed. The conductive layer (for example, 450a) is hereby connected to the first electrode layer (for example, 410b) in the trench (for example, 405). As a result, the first electrode layer (for example, 410b) of one unit cell area (for example, 401b) is electrically connected to the second electrode layer (for example, 430a) formed on another unit cell area (for example, 401a) adjacent to the one unit cell area. Here, the smaller the distance between the trench 406 in which the insulation materials 440a and 440b are buried and the trench 405 in which the insulation materials 440a and 440b are not buried, the smaller an invalid area in which electric current is not generated.

When a predetermined insulation gap is formed between the unit cells by the etching process, the third conductive material can be deposited by using the same deposition method as that of the second conductive material. That is, when the third conductive material is obliquely emitted (OD3) at an angle of θ3 by using an electron beam or a thermal deposition apparatus, deposition straightness causes the third conductive material to be deposited on the other portion except a portion "f" of the first electrode layer 410a, 410b and 410c exposed by etching. The conductive layers 450a, 450b and 450c are formed by depositing the third conductive material.

The formed conductive layers 450a, 450b and 450c allow the first electrode layer (for example, 410b) formed on one unit cell area (for example, 401b) to be electrically connected to the second electrode layer 430' formed on another unit cell area 401b adjacent to the unit cell area 401b. The unit cells are hereby electrically connected in series to each other.

Unlike Fig. 4f, if the insulation materials 440a and 440b are not buried in the trench 406, the first electrode layer 410a' and the second electrode layer 430a, which are formed in the trench 406, are electrically connected to each other through the conductive layer 450a. In this case, an area "R2" as well as an area "R1" functions as a solar cell. A solar cell of the area "R2" is connected in series to a solar cell of the area "R1".

Here, since the area "R2" is smaller than the area "R1", electric current generated from the solar cell of the area "R2" is less than that of the area "R1". Therefore, electric currents flowing through the in-series connected solar cells of the area "R1" and the area "R2" are determined by electric current generated from the solar cell of the area "R2". As a result, the solar cell of the area "R2" reduces the efficiency of the overall solar cell.

On the other hand, as described in the third embodiment, when the insulation materials 440a and 440b are buried, the area "R2" does not function as a solar cell. Therefore, the efficiency of the overall solar cell is not decreased.

In the meantime, as shown in Figs. 4g to 4h, a bus bar area is formed by burying a conductive paste 460 in at least one trench. Since the bus bar area has been already described in detail in the first embodiment, the description thereof will be omitted.

### [Fourth embodiment]

Figs. 5a to 5g show a manufacturing method of an integrated thin-film solar cell according to a fourth embodiment of the present invention.

Referring to Figs. 5a to 5f, unit cell areas 501a, 501b and 501c are between trenches 505a and 505b of a substrate 500. First electrode layers 510a, 510b and 510c, a solar cell layer 520, second electrode layers 530a, 530b and 530c, conductive layers 540a, 540b and 540c and a conductive paste 550 of a bus bar area are formed on the substrate 500.

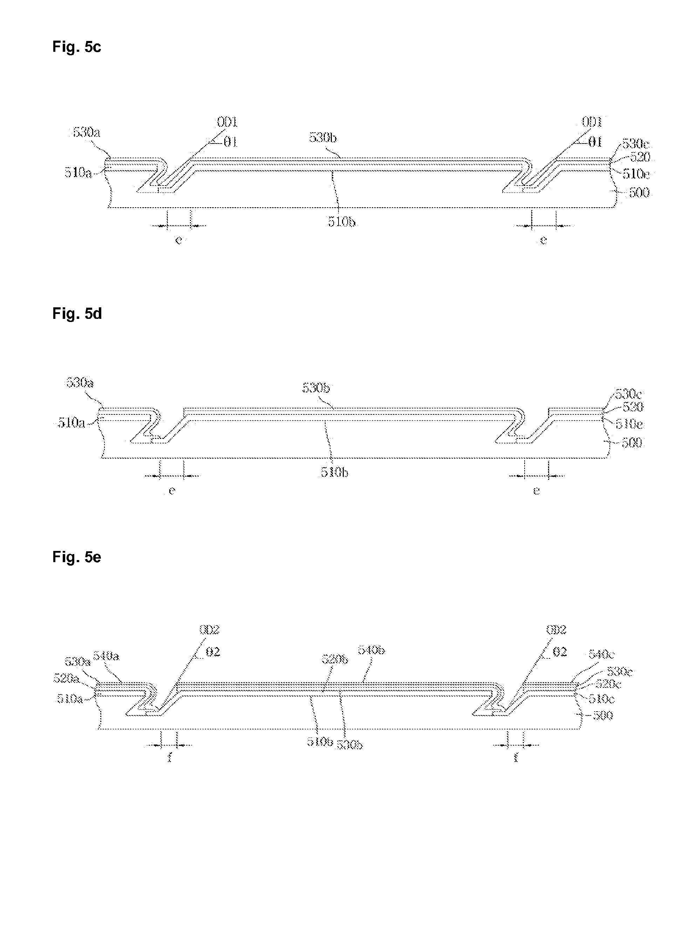

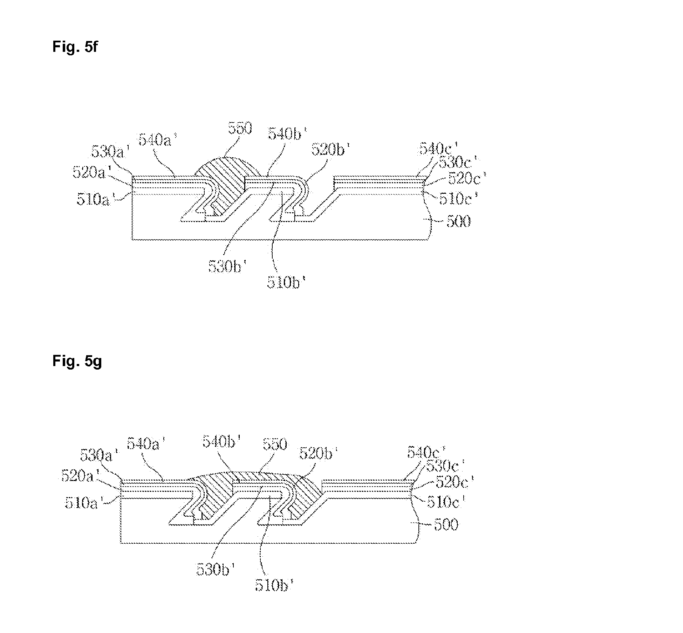

Referring to Fig. 5, the trenches 505a and 505b are formed separately from each other by a predetermined interval on the substrate 500 such that the unit cell areas 501a, 501b and 501c are defined. Here, the trenches 505a and 505b are inclined at an angle of ∠α in one direction. That is, the sides of the trenches 505a and 505b according to the fourth embodiment are formed to be inclined in one direction at an angle of ∠α with respect to a horizontal direction of the substrate 500. While an oblique deposition process is performed for forming the first electrode layer in the second and the third embodiments, the fourth embodiment makes it possible to form first electrode layers 510a, 510b and 510c by using sputtering, an electron beam evaporation or a thermal evaporation and the like instead of the oblique deposition. Unit cells are formed on the unit cell areas 501a, 501b and 501c by the subsequent process.

Referring to Fig. 5a, the first electrode layers 510a, 510b and 510c are formed by a first conductive material on a portion of the bottom surface and one side of each of the trenches 505a and 505b. As described above, the first conductive material can be deposited on the substrate 500 by using various deposition methods such as sputtering, an electron beam deposition or a thermal deposition without performing the oblique deposition. When the first conductive material is deposited on the substrate 500 in a vertical direction of the substrate 500, the trenches 505a and 505b inclined in one direction cause the first conductive material not to be deposited on a portion "d" of the trenches 505a and 505b. The first conductive material includes at least one of ZnO, SnO₂ or ITO.

Referring to Fig. 5b, a solar cell layer 520 is formed on the first electrode layers 510a, 510b and 510c and on the portions of the trenches 505a and 505b on which the first electrode layers 510a, 510b and 510c are not formed. The solar cell layer 520 is made of a photovoltaic material. The solar cell layer 520 is made of an arbitrary material generating electric current from the incidence of sunlight.

Referring to Fig. 5c, a second conductive material is obliquely emitted (OD1) so that the second conductive material is deposited on the solar cell 520. As a result, second electrode layers 530a, 530b and 530c are formed. When the second conductive material is obliquely emitted (OD1) at an angle of θ, deposition straightness causes the second conductive material to be deposited on the solar cell 520.

Since the second conductive material is obliquely deposited, the second conductive material is not deposited on a portion "e" of the solar cell layer 520 formed on the trenches 505a and 505b. The second conductive material is deposited by a deposition method such as an electron beam evaporation or a thermal evaporation and the like, and there is no limit to the deposition method. Based on the described method, formed are the second electrode layers 530a, 530b and 530c which are self-aligned by depositing the second conductive material. Meanwhile, the portion "e" is etched in the subsequent process.

Referring to Fig. 5d, the solar cell layer 520 formed on the trenches 505a and 505b is etched such that the first electrodes 510a, 510b and 510c are exposed. That is, the solar cell layer 520 is actually vertically etched by using the second electrode layers 530a, 530b and 530c as a mask. Here, an etching process is performed on the portion "e" of the solar cell layer 520 having no second conductive material formed thereon.

Solar cell layer patterns 520a, 520b and 520c are formed on the unit cell areas by etching the solar cell layer 520 through use of the aforementioned method. Through the etching process of the solar cell layer 520, the first electrode layers 510a, 510b and 510c formed on the trenches 505a and 505b are exposed.

Referring to Fig. 5e, a third conductive material is obliquely emitted (OD2) on the second electrode layer 530a such that the first electrode layer 510b formed on one unit cell area (for example, 501b) is electrically connected to the second electrode layer 530a formed on another unit cell area (for example, 501a) adjacent to the unit cell area 501b. As a result, a conductive layer (for example, 540a) is formed. The first electrode layer 510b in the trench and the conductive layer 540a are hereby connected to each other in the trench 505a between the one unit cell area 501b and another unit cell area 501a.

When a predetermined insulation gap is formed between the unit cells by the etching process, the third conductive material can be deposited by using the same deposition method as that of the second conductive material. That is, when the third conductive material is obliquely deposited (OD2) at an angle of θ2 by using an electron beam or a thermal deposition apparatus, deposition straightness causes the third conductive material to be deposited on the other portion except a portion "f" of the first electrode layer 510a, 510b and 510c exposed by etching. The conductive layers 540a, 540b and 540c are formed by depositing the third conductive material.

The first electrode layer 510b formed on one unit cell area (for example, 501b) is electrically connected to the second electrode layer 530a formed on another unit cell area (for example, 501a) adjacent to the unit cell area 501b.

Referring to Figs. 5f and 5g, a bus bar area is formed by burying a conductive paste 550 in both trenches formed in ends of the substrate of the integrated thin-film solar cell and in trenches adjacent thereto. As the bus bar area and the conductive paste have been described in the first embodiment, the detailed description thereof will be omitted.

The processes of the fourth embodiment are performed according to self-alignment without a position control device, thereby manufacturing the integrated thin-film solar cell through a relatively simple process.

Meanwhile, since the unit cell area is a minimum unit capable of generating electric current, the unit cell area is not limited to the units provided by the aforementioned first to the fourth embodiments and can be variously defined based on the trench shape of the thin-film solar cell.

## Claims

1. A manufacturing method of an integrated thin-film solar cell, the method comprising:
providing a substrate on which trenches are formed separately from each other by a predetermined interval;
forming a first electrode layer on a portion of the bottom side and one side of each of the trenches by using a first conductive material;
forming a solar cell layer on the first electrode layer and on a portion of the trench on which the first electrode layer is not formed;
forming a second electrode layer by obliquely emitting a second conductive material so that the second conductive material is deposited on the solar cell layer;
etching the solar cell layer formed on the trenches such that the first electrode layer is exposed; and
forming a conductive layer by obliquely emitting a third conductive material and depositing the third conductive material on the second electrode layer such that the exposed first electrode layer is electrically connected to the second electrode layer.

2. The method of claim 1, wherein the first electrode layer is connected to a separate electrode layer formed on a unit cell area.

3. The method of claim 2, wherein the separate electrode layer is formed by a printing method.

4. The method of claim 2, wherein an electrical resistance of the first electrode layer is less than that of the separate electrode layer.

5. The method of claim 1, wherein the solar cell layer is etched by using the second electrode layer as a mask.

6. The method of claim 1, further comprising, after etching the solar cell layer, burying an insulation material in the trench and in another trench adjacent to the trench.

7. The method of claim 6, wherein an intermediate layer is formed inside the solar cell layer.

8. The method of claim 1, wherein a conductive paste is buried in at least one trench among the trenches.

9. The method of claim 8, wherein an interval between the trenches in which the conductive paste is buried is less than an interval between trenches of a solar cell area.

10. The method of claim 1, wherein the trenches are inclined in one direction.

11. The method of claim 1, wherein the substrate corresponds to one of a glass substrate, a polymer substrate or a nano composite substrate, and wherein, under the condition that the glass substrate, the polymer substrate or the nano composite substrate are molten, the trench is formed by using an embossing process before the glass substrate, the polymer substrate or the nano composite substrate is hardened.

12. The method of claim 1, wherein the substrate corresponds to one of a glass substrate, a polymer substrate or a nano composite substrate, and wherein the trench is formed by performing a hot-embossing process on the glass substrate, the polymer substrate or the nano composite substrate.

13. The method of claim 1, wherein the substrate includes a glass material and a polymer material thin-film coated on the glass material or includes a glass material and a nano composite material thin-film coated on the glass material, and wherein the trenches are formed in the polymer material thin-film or the nano composite material thin-film by using a hot-embossing process.

14. The method of claim 1, wherein the substrate includes a glass material and a polymer material thin-film coated on the glass material or includes a glass material and a nano composite material thin-film coated on the glass material, and wherein, during the process in which the polymer material thin-film or the nano composite material thin-film is coated on the glass, the trenches are formed in the polymer material thin-film or the nano composite material thin-film through use of the embossing process.

15. The method of claim 1, wherein the first electrode layer formed on one unit cell area and the second electrode layer formed on another unit cell area adjacent to the one unit cell area are electrically connected to each other by the conductive layer.

16. The method of claim 1, wherein grooves are formed on the substrate between the adjacent trenches, and wherein the solar cell layer formed on the grooves is etched in a process of etching the solar cell layer.

17. The method of claim 16, wherein a width of the groove is less than that of the trench, and wherein a depth of the groove is equal to that of the trench.

18. The method of claim 16, wherein a depth the groove is greater than that of the trench, and wherein a width of the groove is equal to that of the trench.

19. The method of claim 16, wherein the bottom surface of the groove is exposed by etching the solar cell layer formed on the groove.

20. An integrated thin-film solar cell comprising:
a substrate on which trenches are formed separately from each other by a predetermined interval;
a first electrode layer formed on a portion of the bottom side of and one side of each of the trenches;
a solar cell layer formed on the substrate and on the first electrode layer such that a portion of the first electrode layer is exposed;
a second electrode layer formed on the solar cell layer; and
a conductive layer formed on the second electrode layer such that the exposed first electrode layer is electrically connected to the second electrode layer.

21. The integrated thin-film solar cell of claim 20, further comprising a separate electrode layer formed on a unit cell area and connected to the first electrode layer.

22. The integrated thin-film solar cell of claim 20, further comprising an insulation material buried in the trench and in a trench adjacent to the trench.

23. The integrated thin-film solar cell of claim 22, further comprising an intermediate layer formed inside the solar cell layer.

24. The integrated thin-film solar cell of claim 22, wherein an interval between the trenches in which a conductive paste is buried is less than an interval between trenches of a solar cell area.

25. The integrated thin-film solar cell of claim 22, wherein the trenches are inclined in one direction.

26. The integrated thin-film solar cell of claim 20, wherein grooves are formed on the substrate between the adjacent trenches, and wherein the bottom surface of the groove is exposed.

27. The integrated thin-film solar cell of claim 26, wherein a width of the groove is less than that of the trench, and wherein a depth of the groove is equal to that of the trench.

28. The integrated thin-film solar cell of claim 26, wherein a depth the groove is greater than that of the trench, and wherein a width of the groove is equal to that of the trench.

29. The integrated thin-film solar cell of claim 20, wherein a conductive paste is buried in at least one trench among the trenches.

30. The integrated thin-film solar cell of claim 29, wherein an interval between the trenches in which the conductive paste is buried is less than an interval between trenches of a solar cell area.

31. The integrated thin-film solar cell of claim 20, wherein the first electrode layer formed on one unit cell area and the second electrode layer formed on another unit cell area adjacent to the one unit cell area are electrically connected to each other by the conductive layer.
